# EUROPEAN PATENT APPLICATION

(11) **EP 4 528 375 A2**
(43) Date of publication of application: **26.03.2025**
(21) Application number: 24200193.1
(22) Date of filing: 13.09.2024
(51) Int. Cl.: G03F 1/24, G03F 1/48, G03F 1/80

(54) **REFLECTIVE MASK BLANK AND MANUFACTURING METHOD OF REFLECTIVE MASK**

(30) Priority: 22.09.2023 JP 2023157981; 01.08.2024 JP 2024125635
(71) Applicant: Shin-Etsu Chemical Co., Ltd., Chiyoda-ku, Tokyo 1000005 (JP)
(72) Inventor: SAKURAI, Keisuke, Joetsu-shi, 9428601 (JP); MIMURA, Shohei, Joetsu-shi, 9428601 (JP); ISHII, Takeshi, Joetsu-shi, 9428601 (JP); KANEKO, Hideo, Joetsu-shi, 9428601 (JP)
(74) Representative: Mewburn Ellis LLP

(57) **Abstract**

An absorption film of a reflective mask blank that is formed on a protection film and can be etched by ion beam etching or methanol etching is patterned by providing an etching prevention film contacted with both of the protection film and the absorption film, and a first hard mask film on the absorption film, and patterning the absorption film by ion beam etching or methanol etching with using a pattern of the first hard mask film as an etching mask.

## Description

### TECHNICAL FIELD

The present invention relates to a reflective mask blank which is a material for a reflective mask used in manufacturing semiconductor devices such as LSIs, and a method of manufacturing a reflective mask from the reflective mask blank.

### BACKGROUND

In a manufacturing process of a semiconductor device, a photolithography technique in which a circuit pattern formed on a transfer mask is transferred onto a semiconductor substrate (a semiconductor wafer) through a reduction projection optical system with irradiating exposure light to the transfer mask is repeatedly used. Conventionally, a mainstream wavelength of the exposure light is 193 nm by argon fluoride (ArF) excimer laser light. A pattern with dimensions smaller than exposure wavelength has finally been formed by adopting a process called multi-patterning in which exposure processes and processing processes are combined multiple times.

However, since it is necessary to form further fine patterns under continuous miniaturization of device patterns, an extreme ultraviolet lithography technique utilizing, as exposure light, extreme ultraviolet (hereafter refers to as "EUV") light having a shorter wavelength than the wavelength of ArF excimer laser light has been used. The EUV light is light having a wavelength of about 0.2 to 100 nm, in particular, light having a wavelength of around 13.5 nm. The EUV light has a very low transparency to a substance and cannot be utilized for a conventional transmissive projection optical system or mask, thus, reflection type optical elemental devices are applied. Therefore, a reflective mask has been also proposed as a mask for the pattern transfer.

In the reflective mask, generally, a multilayer reflection film that reflects EUV light is formed on one main surface of a low thermal expansion substrate made of glass, and further, a patterned absorption film that absorbs EUV light is formed on the multilayer reflection film. On the other hand, a material (including also a material in which a resist film is formed) before patterning the absorption film is called a reflective mask blank, and is used as a material for the reflective mask. In the reflective mask blank, a multilayer reflection film that reflects EUV light is formed on one main surface of a low thermal expansion substrate made of glass, and further, an absorption film that absorbs EUV light is formed on the multilayer reflection film. The reflective mask blank has a basic structure that includes the multilayer reflection film and the absorption film.

As the multilayer reflection film, a Mo/Si multilayer reflection film in which molybdenum (Mo) layers and silicon (Si) layers are alternately laminated to ensure a reflectance for EUV light is commonly used. Further, as a material for the absorption film, a material containing, as a main component, tantalum (Ta) or others, which has a relatively large extinction coefficient with respect to EUV light, is used (Patent Document 1: JP-A 2002-246299). On the other hand, a back surface conducting film such as a metal film is formed on the other main surface of the substrate for electrostatic chucking in holding the reflective mask on an exposure apparatus. As the back surface conducting film, a film containing manly chromium (Cr) or tantalum (Ta) is used.

Further, a protection film for protection the multilayer reflection film is usually formed between the multilayer reflection film and the absorption film. The protection film is formed to protect the multilayer reflection film in exposure to etching gas in etching that is performed for forming a mask pattern in the absorption film or in exposure to a cleaning liquid in cleaning that is performed after forming the mask pattern, further, to protect the multilayer reflection film so as not to be damaged in pattern correction processing that is performed when a defect is detected after forming the mask pattern. As a material for the protection film, for example, ruthenium (Ru) is used (Patent Document 2: JP-A 2002-122981), and it has also been proposed to use a material in which niobium (Nb), rhodium (Rh), zirconium (Zr) or others are added to ruthenium (Ru).

### Citation List

Patent Document 1: JP-A 2002-246299
Patent Document 2: JP-A 2002-122981

### SUMMARY OF THE INVENTION

In a reflective mask blank used for EUV exposure, a material containing tantalum (Ta) is generally used for an absorption film. When a pattern of the absorption film composed of a material containing tantalum (Ta) is formed, dry etching using a chlorine-based gas or a fluorine-based gas is commonly used.

To reduce shadowing effect in exposure using a reflective mask, a thinned absorption film is required according to a demand to form a finer pattern of the absorption film. However, there is a limit to thin the absorption film using the material containing tantalum (Ta). Therefore, there is a demand for an absorption film composed of a material containing another metal. For a material that can thin the absorption film, it is necessary to use a material that has a high extinction coefficient k compared with that of the material containing tantalum (Ta), and further, a material that has a low refraction index n compared with that of the material containing tantalum (Ta) in case that the absorption film is formed to act as a phase shift film.

However, among materials containing another metal, materials having a higher extinction coefficient k compared with that of the material containing tantalum (Ta) and materials having a lower refractive index k compared with that of the material containing tantalum (Ta) tend to be inferior in etching processability. In this case, it is hard to form a pattern by dry etching using a chlorine-based gas or a fluorine-based gas, which is used in forming a pattern of the absorption film composed of a material containing tantalum (Ta).

To form a pattern of the absorption film that is hard to form the pattern by dry etching using a chlorine-based gas or a fluorine-based gas, other etchings, for example, ion beam etching or methanol etching may be used. However, since a protection film formed under (at the substrate-side of) the absorption film, further a multilayer reflection film can be etched by these etchings, these etchings damage to the protection film, further the multilayer reflection film after etching the absorption film.

The present invention has been made to solve the above problems, and an object of the present invention is to provide a reflective mask blank in which films formed under (at the substrate-side of) an absorption film are hard to be damaged are included, even when the absorption film is composed of a material containing a metal which can be thinned, and even when etching having high processability that differs from dry etching using a chlorine-based gas or a fluorine-based gas is used to the absorption film for etching the absorption film in patterning the absorption film. Further, another object of the present invention is to provide a method of manufacturing a reflective mask from the reflective mask blank.

The inventors have made earnestly studies to solve the above problems. As a result, the inventors found that the problems can be solved by forming an absorption film of a reflective mask blank with a material containing a metal which can thin the absorption film, and forming an etching prevention film that intervenes between the absorption film and a protection film formed under (at the substrate-side of) the absorption film to protect the protection film from reaching the etching to the protection film in patterning of the absorption film, further, found that the absorption film can be processed and patterned by providing a hard mask film on (at the side remote from the substrate of) the absorption film, and utilizing a pattern of the hard mask film as an etching mask.

In one aspect, the invention provides a reflective mask blank which is a material for a reflective mask used in EUV lithography utilizing EUV light as exposure light, including
a substrate,
a multilayer reflection film that is formed on one main surface of the substrate, and reflects the exposure light,
a protection film that is formed on the multilayer reflection film, and
an absorption film that is formed on the protection film, and absorbs the exposure light, wherein
the reflective mask blank includes an etching prevention film that is formed in contact with both of the protection film and the absorption film, and a first hard mask film that is formed on the absorption film.

Preferably, the etching prevention film has an etching selectivity of less than 1 to the absorption film when ion beam etching is performed to the absorption film and the etching prevention film under the same condition.

Preferably, the etching prevention film has an etching selectivity of less than 1 to the absorption film when methanol etching is performed to the absorption film and the etching prevention film under the same condition.

Preferably, the etching prevention film has an etching selectivity of more than 1 to the absorption film when dry etching using a chlorine-based gas or a fluorine-based gas is performed to the absorption film and the etching prevention film under the same condition.

Preferably, the absorption film has an etching selectivity of not more than 0.3 to the first hard mask film when dry etching using a chlorine-based gas or a fluorine-based gas is performed to the first hard mask film and the absorption film under the same condition.

Preferably, the reflective mask blank further includes a second hard mask film on the first hard mask film.

Preferably, the second hard mask film contains chromium (Cr).

In another aspect, the invention provides a first manufacturing method of a reflective mask from the reflective mask blank, including the steps of:
dry etching the first hard mask film with using a chlorine-based gas or a fluorine-based gas,
patterning the absorption film by ion beam etching or ion beam etching and methanol etching, and
dry etching the etching prevention film with using a chlorine-based gas or a fluorine-based gas.

In another aspect, the invention provides a second manufacturing method of a reflective mask from the reflective mask blank that includes the second hard mask film, including the steps of:
dry etching the second hard mask film with using a gas containing chlorine (Cl) and oxygen (O),
dry etching the first hard mask film with using a chlorine-based gas or a fluorine-based gas,
patterning the absorption film by ion beam etching or ion beam etching and methanol etching, and
dry etching the etching prevention film with using a chlorine-based gas or a fluorine-based gas.

In further aspect, the invention provides a third manufacturing method of a reflective mask from a reflective mask blank including
a substrate,
a multilayer reflection film that is formed on one main surface of the substrate, and reflects exposure light,
a protection film that is formed on the multilayer reflection film, and
an absorption film that is formed on the protection film, and absorbs the exposure light, by patterning the absorption film, wherein
in the reflective mask blank, an etching prevention film is provided so as to contact to both of the protection film and the absorption film, and a first hard mask film is provided on the absorption film, wherein
the method includes the patterning of the absorption film by the steps of:
   forming a pattern of the first hard mask film by dry etching using a chlorine-based gas or a fluorine-based gas,
   patterning the absorption film by ion beam etching or ion beam etching and methanol etching with using the pattern of the first hard mask film as an etching mask, and
   removing the etching prevention film by dry etching using a chlorine-based gas or a fluorine-based gas.

Preferably, in the third manufacturing method, in the reflective mask blank, a second hard mask film is further provided on the first hard mask film, and
a pattern of the second hard mask film is formed by dry etching using a gas containing chlorine (Cl) and oxygen (O), and
the pattern of the first hard mask film is formed with using the pattern of the second hard mask film as an etching mask.

Preferably, in the third manufacturing method, the etching prevention film has an etching selectivity of less than 1 to the absorption film in the ion beam etching.

Preferably, in the third manufacturing method, the etching prevention film has an etching selectivity of less than 1 to the absorption film in the methanol etching.

Preferably, in the removing step of the etching prevention film, the etching prevention film has an etching selectivity of more than 1 to the absorption film in the dry etching using a chlorine-based gas or a fluorine-based gas.

Preferably, in the forming step of the pattern of the first hard mask film, the absorption film has an etching selectivity of not more than 0.3 to the first hard mask film in the dry etching using a chlorine-based gas or a fluorine-based gas.

Preferably, the absorption film contains a metal excluding tantalum (Ta).

Preferably, the metal excluding tantalum (Ta) is at least one metal selected from the group consisting of platinum (Pt), nickel (Ni), gold (Au), palladium (Pd), rhodium (Rh), iridium (Ir), silver (Ag), iron (Fe), cobalt (Co) and zinc (Zn).

Preferably, the etching prevention film contains tantalum (Ta).

Preferably, the first hard mask film contains tantalum (Ta).

Preferably, each of the etching prevention film and the first hard mask film contains tantalum (Ta) and nitrogen (N).

Preferably, the multilayer reflection film includes a high refractive index layer composed of a material containing silicon (Si) and a low refractive index layer composed of a material containing molybdenum (Mo).

Preferably, the protection film contains ruthenium (Ru).

### ADVANTAGEOUS EFFECTS

According to the invention, a reflective mask blank including a thinner absorption film that can reduce shadowing effect can be provided. Further, a reflective mask including a fine absorption film pattern can be provided by patterning the absorption film composed of a material containing a metal which can be thinned without damages to a protection film formed under (at the substrate-side of) the absorption film.

### BRIEF DESCRIPTION OF THE DRAWINGS

FIG. 1 is a cross-sectional view illustrating an example of a reflective mask blank (first embodiment) of the invention.
FIG. 2 is a cross-sectional view illustrating an example of a reflective mask blank (second embodiment) of the invention.
FIG. 3 is a cross-sectional view illustrating an example of a reflective mask of the invention.

### FURTHER EXPLANATIONS; OPTIONS AND PREFERENCES

A reflective mask blank of the invention includes a substrate, a multilayer reflection film that is formed on one main surface (front surface) of the substrate, and reflects exposure light, a protection film that is formed on the multilayer reflection film, and an absorption film that is formed on the protection film, and absorbs the exposure light. Further, the reflective mask blank of the invention includes an etching prevention film that is formed between the protection film and the absorption film. Further, the reflective mask blank of the invention includes a first hard mask film that is formed on the absorption film.

The reflective mask blank of the invention is suitable for a material for a reflective mask used in EUV lithography utilizing EUV light as exposure light. A wavelength of EUV light used in EUV lithography utilizing EUV light as exposure light is 13 to 14 nm, commonly about 13.5 nm. A reflective mask blank and a reflective mask using EUV light as exposure light are also called an EUV mask blank and an EUV mask, respectively.

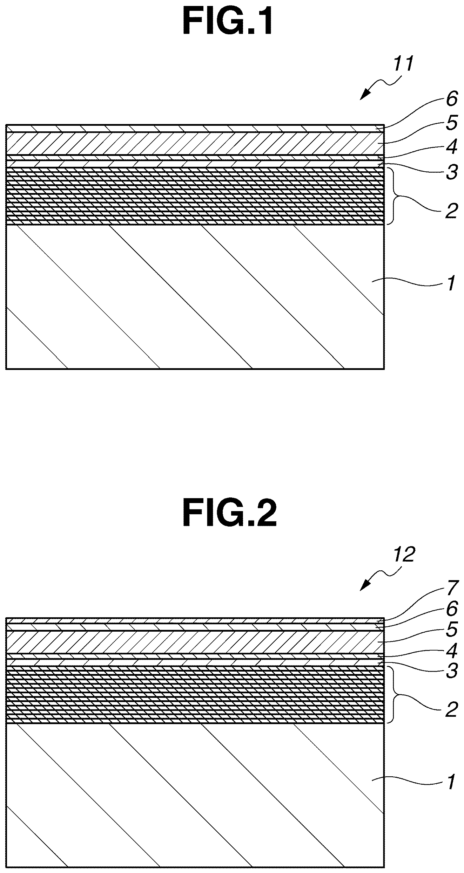

FIG. 1 is a cross-sectional view illustrating an example of a reflective mask blank (first embodiment) of the invention. This reflective mask blank 11 includes a substrate 1, and on the substrate 1, a multilayer reflection film 2 that is formed in contact with the substrate 1, a protection film 3 that is formed in contact with the multilayer reflection film 2, an etching prevention film 4 that is formed in contact with the protection film 3, an absorption film 5 that is formed in contact with the etching prevention film 4, and a first hard mask film 6 that is formed in contact with the absorption film 5.

For use in EUV light exposure, the substrate preferably has low thermal expansion property. For example, the substrate is preferably composed of a material having a coefficient of thermal expansion within ±2×10⁻⁸/°C, preferably within ±5×10⁻⁹/°C. As the material, a titania-doped quartz glass (SiO₂-TiO₂-based glass) is exemplified. Further, a substrate having a sufficiently flatted surface is preferably used. The main surface of the substrate has a surface roughness, as an RMS value, of preferably not more than 0.5 nm, more preferably not more than 0.2 nm. Such surface roughness can be obtained by polishing of the substrate, or others. The substrate preferably has dimensions of 152 mm-square in main surface and 6.35 mm in thickness. A substrate having the dimensions is so-called a 6025 substrate, which has dimensions of 6 inches-square in the main surface and 0.25 inches in the thickness.

The multilayer reflection film is a film that reflects exposure light, in the reflective mask. The multilayer reflection film is preferably formed in contact with one main surface of the substrate, however, may be formed via another film such as an underlayer film on the one main surface of the substrate. The multilayer reflection film includes a high refractive index layer having a comparatively high refractive index with respect to exposure light and a low refractive index layer having a comparatively low refractive index with respect to the exposure light. The multilayer reflection film generally has a periodically laminated structure in which high refractive index layers and low refractive index layers are alternately laminated.

The high refractive index layer is preferably composed of a material containing silicon (Si). The high refractive index layer may contain at least one additive element selected from the group consisting of oxygen (O), nitrogen (N), carbon (C), boron (B) and hydrogen (H). Further, the high refractive index layer may be configured by a multilayer including a layer containing the additive element and a layer not containing the additive element. The high refractive index layer has a thickness of preferably not less than 3.5 nm, more preferably not less than 4 nm, and preferably not more than 4.9 nm, more preferably not more than 4.4 nm.

The low refractive index layer is preferably composed of a material containing molybdenum (Mo). The low refractive index layer may be composed of a material containing ruthenium (Ru). The low refractive index layer may contain at least one additive element selected from the group consisting of oxygen (O), nitrogen (N), carbon (C), boron (B) and hydrogen (H). Further, the low refractive index layer may be configured by a multilayer including a layer containing the additive element and a layer not containing the additive element. The low refractive index layer has a thickness of preferably not less than 2.1 nm, more preferably not less than 2.6 nm, and preferably not more than 3.5 nm, more preferably not more than 3 nm.

The periodically laminated structure may include the high refractive index layer and the low refractive index layer, and may include at least one high refractive index layer and at least one low refractive index layer in one cycle. The one cycle includes at least two layers and may be configured by, for example, one high refractive index layer and one low refractive index layer. Further, the one cycle may include at least two high refractive index layers that have different compositions (for example, different ratios in composition, or different compositions with and without an additive element) each other, and may include at least two low refractive index layers that have different compositions (for example, different ratios in composition, or different compositions with and without an additive element) each other. In this case, the one cycle includes at least three layers and may include four or five or more layers, however, preferably not more than eight layers. The periodically laminated structure has the cycles of preferably not less than 30 cycles, and preferably not more than 50 cycles, more preferably not more than 40 cycles. In the case that the low refractive index layer is composed of a material containing ruthenium (Ru), the layer remotest from the substrate (uppermost layer) in the periodically laminated structure is preferably the high refractive index layer.

A thickness of the multilayer reflection film having the periodically laminated structure is adjusted according to an exposure wavelength and an incident angle of the exposure light, and the multilayer reflection film has a thickness of preferably not less than 200 nm, more preferably not less than 270 nm, and preferably not more than 400 nm, more preferably not more than 290 nm.

Examples of methods for forming the multilayer reflection film include a sputtering method in which, to perform sputtering, power is supplied to a target, and plasma of an atmospheric gas is formed (an atmospheric gas is ionized) by the supplied power, and an ion beam sputtering method in which a target is irradiated with ion beam. The sputtering methods include a DC sputtering method in which a DC voltage is applied to a target, and an RF sputtering method in which a high frequency voltage is applied to a target. The sputtering method is a film forming method that utilizes sputtering phenomenon caused by gas ions generated by applying a voltage to a target with feeding a sputtering gas into a chamber to ionize the gas. Particularly, a magnetron sputtering method has an advantage in productivity. The power may be applied to the target by a DC system or an RF system. The DC system includes also a pulse sputtering in which a negative bias applied to the target is inverted for a short time to prevent charge-up of the target.

The multilayer reflection film may be formed by, for example, a sputtering method using a sputtering apparatus to which a plurality of targets can be attached. In particular, the multilayer reflection film may be formed with using, as targets, targets appropriately selected from the group consisting of a molybdenum (Mo) target for forming a molybdenum (Mo)-containing layer, a ruthenium (Ru) target for forming a ruthenium (Ru)-containing layer, a silicon (Si) target for forming a silicon (Si)-containing layer, and other targets, and with using, as a sputtering gas, a rare gas such as helium (He) gas, argon (Ar) gas, krypton (Kr) gas and xenon (Xe) gas.

Further, in the case that the sputtering is reactive sputtering using a reactive gas, for example, a nitrogen-containing gas such as nitrogen (N₂) gas to form a nitrogen (N)-containing film, an oxygen-containing gas such as oxygen (O₂) gas to form an oxygen (O)-containing film, a nitrogen oxide gas such as nitrous oxide (N₂O) gas, nitrogen monoxide (NO) gas and nitrogen dioxide (NO₂) gas to form a nitrogen (N) and oxygen (O)-containing film, a carbon oxide gas such as carbon monoxide (CO) gas and carbon dioxide (CO₂) gas to form a carbon (C) and oxygen (O)-containing film, a hydrogen-containing gas such as hydrogen (H₂) gas to form a hydrogen (H)-containing film, or a hydrocarbon gas such as methane (CH₄) gas to form a carbon (C) and hydrogen (H)-containing film may be used with the rare gas.

Moreover, a molybdenum (Mo) target added with boron (B) (a molybdenum boride (MoB) target), or a silicon (Si) target added with boron (B) (a silicon boride (SiB) target) may be used to form a boron (B)-containing layer.

The protection film is also called a capping film, and is a film for protecting the multilayer reflection film. The protection film is generally formed in contact with the multilayer reflection film. The protection film preferably contains ruthenium (Ru), and is preferably composed of a material containing ruthenium (Ru).

Examples of the materials containing ruthenium (Ru) include simple substance of ruthenium (Ru), and an alloy containing ruthenium (Ru) and another metal or metalloid different from ruthenium (Ru). Examples of the other metals or metalloids different from ruthenium (Ru) include niobium (Nb), rhenium (Re), zirconium (Zr), titanium (Ti), chromium (Cr), silicon (Si) and others. Among the materials containing ruthenium (Ru), simple substance of ruthenium (Ru) or an alloy containing ruthenium (Ru) and niobium (Nb) is particularly preferred. A content of the other metal or metalloid different from ruthenium (Ru) in the protection film is preferably not more than 30 at%, more preferably not more than 20 at% on average for the whole of the film. A lower limit of the content of the other metal or metalloid different from ruthenium (Ru) in the protection film is preferably not less than 5 at%, more preferably not less than 10 at% on average for the whole of the film, however, not particularly limited thereto.

The protection film may have a single layer structure or a multilayer structure combining multiple layers having different compositions. Further, each layer constituting the single layer or the multiple layers may have a compositional graded structure in which the composition continuously varies along the thickness direction. The protection film has a thickness of preferably not less than 2 nm, more preferably not less than 3 nm, and preferably not more than 5 nm, more preferably not more than 4 nm.

The protection film can be formed by sputtering using, as a target, an appropriate target selected from the group consisting of a ruthenium (Ru) target, a target of the other metal or metalloid different from ruthenium (Ru), in particular, a niobium (Nb) target, a rhenium (Re) target, a zirconium (Zr) target, a titanium (Ti) target, a chromium (Cr) target, a silicon (Si) target, a target in which two or more selected from the group consisting of niobium (Nb), rhenium (Re), zirconium (Zr), titanium (Ti), chromium (Cr) and silicon (Si) are mixed, and a target in which ruthenium (Ru) is mixed with at least one the other metal or metalloid different from ruthenium (Ru) selected from the group consisting of niobium (Nb), rhenium (Re), zirconium (Zr), titanium (Ti), chromium (Cr) and silicon (Si), and using, as a puttering gas, a rare gas such as helium (He) gas, argon (Ar) gas, krypton (Kr) gas and xenon (Xe) gas. The sputtering is preferably performed by a magnetron sputtering method.

In the reflective mask, the absorption film is a film that absorbs exposure light and reduces reflectance. In the reflective mask, a transfer pattern is formed by a difference in reflectance between a portion where an absorption film is formed and a portion where an absorption film is not formed. The absorption film may consist of a single layer or multiple layers, and an antireflection layer may be formed at the surface portion of the absorption film.

The invention is suitable for the case that the material constituting the absorption film is a material that is less susceptible to be etched by dry etching using a chlorine-based gas or a fluorine-based gas, particularly, substantively that is not be etched by dry etching using a chlorine-based gas or a fluorine-based gas.

In the invention, the absorption film contains preferably a metal excluding tantalum (Ta), more preferably a metal excluding both tantalum (Ta) and chromium (Cr). In the invention, the absorption film is preferably free of tantalum (Ta). Further, the absorption film is preferably free of the chromium (Cr). The absorption film is a film composed of a material that absorbs EUV light, and can be processed into a pattern.

The metal excluding tantalum (Ta) is preferably at least one metal selected from the group consisting of platinum (Pt), nickel (Ni), gold (Au), palladium (Pd), rhodium (Rh), iridium (Ir), silver (Ag), iron (Fe), cobalt (Co) and zinc (Zn). The absorption film can be thinned by a material contains the metal, compared with an absorption film composed of a material containing tantalum (Ta). Among the metals, platinum (Pt) or nickel (Ni) is more preferable. The material constituting the absorption film may contain oxygen (O), nitrogen (N), carbon (C) or other metals, and may contain another metal, for example ruthenium (Ru) with the at least one metal selected from the group consisting of platinum (Pt), nickel (Ni), gold (Au), palladium (Pd), rhodium (Rh), iridium (Ir), silver (Ag), iron (Fe), cobalt (Co) and zinc (Zn).

In the absorption film, the metal excluding tantalum (Ta), particularly, the metal excluding both tantalum (Ta) and chromium (Cr) has a content of preferably not less than 20 at%, more preferably not less than 30 at%. In the absorption film, the metal excluding tantalum (Ta), particularly, the metal excluding both tantalum (Ta) and chromium (Cr) has a content of 100 at% or less, preferably less than 100 at%, more preferably not more than 90 at%.

The absorption film has a thickness of preferably not less than 10 nm, more preferably not less than 20 nm, even more preferably not less than 30 nm, and preferably not more than 80 nm, more preferably not more than 70 nm. The absorption film has a sheet resistance of preferably not more than 1×10⁶ Ω/square, more preferably not more than 1×10⁵ Ω/square. The absorption film has a surface roughness Sq of preferably not more than 0.8 nm, more preferably not more than 0.6 nm.

The absorption film can be formed by sputtering, and the sputtering is preferably performed by a magnetron sputtering method. In particular, the absorption film may be formed by sputtering using an appropriate target selected, according to the composition, from the group consisting of a target of a metal constituting the absorption film, a target of a compound of a metal constituting the absorption film (a target containing a metal constituting the absorption film, and oxygen (O), nitrogen (N), carbon (C) or others), and using, as a sputtering gas, a rare gas such as helium (He) gas, argon (Ar) gas, krypton (Kr) gas and xenon (Xe) gas, or according to the composition, the absorption film may be formed by reactive sputtering using, as sputtering gases, a reactive gas such as an oxygen-containing gas, a nitrogen-containing gas, a carbon-containing gas or other gases with the rare gas. Examples of the reactive gases include oxygen (O₂) gas, nitrogen (N₂) gas, nitrogen oxide gases such as nitrous oxide (N₂O) gas, nitrogen monoxide (NO) gas and nitrogen dioxide (NO₂) gas, and carbon oxide gases such as carbon monoxide (CO) gas and carbon dioxide (CO₂) gas.

In the invention, the etching prevention film is a film for protecting the protection film from reaching the etching to the protection film in patterning of the absorption film. The etching prevention film is generally formed in contact with both of the protection film and the absorption film. The etching prevention film preferably has etching resistance and a thickness so that the etching in forming a pattern of the absorption film cannot reach to the protection film under (at the substrate-side of) the etching prevention film, in other words, the etching prevention film does not disappear during the etching in forming a pattern of the absorption film, after the etching in forming a pattern of the absorption film reaches to the etching prevention film, for example, during over-etching.

In the case that the material constituting the absorption film is a material that is less susceptible to be etched by dry etching using a chlorine-based gas or a fluorine-based gas, ion beam etching or methanol etching is preferably used as etching for forming a pattern of the absorption film. However, the protection film can also be etched by these etchings. Therefore, the etching prevention film is preferably composed of a material that is less susceptible to be etched by ion beam etching and methanol etching compared with the absorption film, i.e., the etching prevention film preferably has a lower etching rate compared with that of the absorption film. In particular, the etching prevention film preferably has an etching selectivity to the absorption film of preferably less than 1, more preferably not more than 0.9, even more preferably not more than 0.8 in ion beam etching. The etching prevention film preferably has an etching selectivity to the absorption film of preferably less than 1, more preferably not more than 0.9, even more preferably not more than 0.8 in methanol etching. In the invention, the etching selectivity is a ratio of etching rates of the two films in the same condition. For example, an etching selectivity of the etching prevention film to the absorption film is a ratio of an etching rate of the etching prevention film to an etching rate of the absorption film.

On the other hand, the etching prevention film is generally removed by etching after forming the pattern of the absorption film. Thus, in the case that the material constituting the absorption film is a material that is less susceptible to be etched by dry etching using a chlorine-based gas or a fluorine-based gas, the etching prevention film is preferably composed of a material that is easily etched by the dry etching using a chlorine-based gas or a fluorine-based gas, i.e., the etching prevention film preferably has a high etching rate compared with that of the absorption film. In particular, the etching prevention film preferably has an etching selectivity to the absorption film of preferably more than 1, more preferably not less than 5, even more preferably not less than 10 in dry etching using a chlorine-based gas or a fluorine-based gas.

In the invention, examples of dry etchings using a chlorine-based gas include dry etching using a gas containing chlorine (Cl) such as dry etching using a gas containing chlorine (Cl₂) gas and dry etching using a gas containing hydrogen chloride (HCl) gas, and dry etching using a gas containing chlorine (Cl) and oxygen (O) such as dry etching using a gas containing chlorine (Cl₂) gas and oxygen (O₂) gas. On the other hand, examples of dry etchings using a fluorine-based gas include dry etching using a gas containing carbon tetrafluoride (CF₄) gas or sulfur hexafluoride (SF₆) gas.

The etching prevention film preferably contains tantalum (Ta), and is preferably composed of a material containing tantalum (Ta). The etching prevention film preferably has a tantalum (Ta) content of not less than 30 at%, more preferably not less than 40 at%. The material constituting the etching prevention film may contain oxygen (O), nitrogen (N), carbon (C) or others. Particularly, the etching prevention film preferably contains nitrogen (N), and more preferably consists of tantalum (Ta) and nitrogen (N). In the case that the metal contained in the absorption film is platinum (Pt) or nickel (Ni), the etching prevention film consisting of tantalum (Ta) and nitrogen (N) is particularly preferable. In the case that the etching prevention film contains tantalum (Ta) and nitrogen (N), particularly, consists of tantalum (Ta) and nitrogen (N), the etching prevention film has a nitrogen content of preferably not less than 10 at%, more preferably not less than 40 at%, and preferably not more than 70 at%, more preferably not more than 60 at%.

The material constituting the etching prevention film may contain a metal excluding tantalum (Ta), preferably a metal excluding both tantalum (Ta) and chromium (Cr), and particularly a metal that is easily etched by dry etching using a chlorine-based gas or a fluorine-based gas. However, the material is preferably free of the metal contained in the absorption film, particularly, platinum (Pt), nickel (Ni), gold (Au), palladium (Pd), rhodium (Rh), iridium (Ir), silver (Ag), iron (Fe), cobalt (Co) and zinc (Zn).

The etching prevention film has a thickness of preferably not more than the thickness of the absorption film, more preferably not more than half of the thickness of the absorption film. In particular, since it is preferable that the total thickness of the absorption film and the etching prevention film (the thickness of the portion of a circuit pattern or a mask pattern in a reflective mask) is thin, the etching prevention film has a thickness of preferably not more than 10 nm, more preferably not more than 5 nm. On the other hand, the etching prevention film has a thickness of preferably not less than 1 nm, more preferably not less than 2 nm to prevent the etching in patterning of the absorption film from reaching to the protection film.

The etching prevention film can be formed by sputtering, and the sputtering is preferably performed by a magnetron sputtering method. In particular, the etching prevention film may be formed by sputtering using an appropriate target selected, according to the composition, from the group consisting of a target of a metal (for example, tantalum (Ta)) constituting the etching prevention film, a target of a compound of a metal constituting the etching prevention film (a target containing a metal constituting the etching prevention film, and oxygen (O), nitrogen (N), carbon (C) or others), and using, as a sputtering gas, a rare gas such as helium (He) gas, argon (Ar) gas, krypton (Kr) gas and xenon (Xe) gas, or according to the composition, the etching prevention film may be formed by reactive sputtering using, as sputtering gases, a reactive gas such as an oxygen-containing gas, a nitrogen-containing gas, a carbon-containing gas or other gases with the rare gas. Examples of the reactive gases include oxygen (O₂) gas, nitrogen (N₂) gas, nitrogen oxide gases such as nitrous oxide (N₂O) gas, nitrogen monoxide (NO) gas and nitrogen dioxide (NO₂) gas, and carbon oxide gases such as carbon monoxide (CO) gas and carbon dioxide (CO₂) gas.

In the invention, the first hard mask is a film that acts as an etching mask in etching for forming a pattern of the absorption film. In the invention, the first hard mask film is provided on the absorption film since ion beam etching or methanol etching is applied as etching for forming a pattern of the absorption film. The first hard mask film is generally formed in contact with the absorption film. In the case that the absorption film includes a layer that assumes function for reducing reflectance at the wavelength of light used in inspection such as pattern inspection (a reflectance reduction layer) at the top portion of the absorption film, the first hard mask film may be formed on the reflectance reduction layer of the absorption film.

In the case that the material constituting the absorption film is a material that is less susceptible to be etched by dry etching using a chlorine-based gas or a fluorine-based gas, ion beam etching or methanol etching is preferably used as etching for forming a pattern of the absorption film. Therefore, the first hard mask film is preferably composed of a material that is less susceptible to be etched by ion beam etching and methanol etching compared with the absorption film, i.e., the first hard mask film preferably has a lower etching rate compared with that of the absorption film. In particular, the first hard mask film preferably has an etching selectivity to the absorption film of preferably less than 1, more preferably not more than 0.9, even more preferably not more than 0.8 in ion beam etching. The first hard mask film preferably has an etching selectivity to the absorption film of preferably less than 1, more preferably not more than 0.9, even more preferably not more than 0.8 in methanol etching.

On the other hand, the first hard mask film is generally removed by etching after forming the pattern of the absorption film. Thus, in the case that the material constituting the absorption film is a material that is less susceptible to be etched by dry etching using a chlorine-based gas or a fluorine-based gas, the first hard mask film is preferably composed of a material that is easily etched by the dry etching using a chlorine-based gas or a fluorine-based gas, in other words, the absorption film is comparatively less susceptible to be etched by dry etching using a chlorine-based gas or a fluorine-based gas, i.e., the first hard mask film preferably has a high etching rate compared with that of the absorption film. In particular, the absorption film preferably has an etching selectivity to the first hard mask film of preferably not more than 0.3, more preferably not more than 0.15 in dry etching using a chlorine-based gas or a fluorine-based gas.

The first hard mask film preferably contains tantalum (Ta), and is preferably composed of a material containing tantalum (Ta). The first hard mask film preferably has a tantalum (Ta) content of not less than 30 at%, more preferably not less than 40 at%.

The material constituting the first hard mask film may contain oxygen (O), nitrogen (N), carbon (C) or others. Particularly, the first hard mask film preferably contains nitrogen (N), and more preferably consists of tantalum (Ta) and nitrogen (N). In the case that the metal contained in the absorption film is platinum (Pt) or nickel (Ni), the first hard mask film consisting of tantalum (Ta) and nitrogen (N) is particularly preferable. In the case that the first hard mask film contains tantalum (Ta) and nitrogen (N), particularly, consists of tantalum (Ta) and nitrogen (N), the first hard mask film has a nitrogen content of preferably not less than 10 at%, more preferably not less than 40 at%, and preferably not more than 70 at%, more preferably not more than 60 at%.

The material constituting the first hard mask film may contain a metal excluding tantalum (Ta), preferably a metal excluding both tantalum (Ta) and chromium (Cr), and particularly a metal that is easily etched by dry etching using a chlorine-based gas or a fluorine-based gas. However, the material is preferably free of the metal contained in the absorption film, particularly, platinum (Pt), nickel (Ni), gold (Au), palladium (Pd), rhodium (Rh), iridium (Ir), silver (Ag), iron (Fe), cobalt (Co) and zinc (Zn).

The first hard mask film is preferably removed at the same time in removing the etching prevention film by etching. Therefore, the first hard mask film preferably composed of the same element(s), particularly, at the same composition ratio in the etching prevention film. Further, the etching rate of the first hard mask film is preferably set to be approximately equal to the etching rate of the etching prevention film, in particular, the first hard mask film preferably has an etching selectivity to the etching prevention film of not less than 0.5 and not more than 1.5.

The first hard mask film has a thickness such that the first hard mask film will remain after etching in forming a pattern of the absorption film, and has preferably a thickness that will remain at the same thickness of the etching prevention film or at less thickness of the etching prevention film. In particular, the first hard mask film has a thickness of preferably not less than 2 nm, more preferably not less than 5 nm, and preferably not more than 30 nm, more preferably not more than 15 nm.

The first hard mask film can be formed by sputtering, and the sputtering is preferably performed by a magnetron sputtering method. In particular, the first hard mask film may be formed by sputtering using an appropriate target selected, according to the composition, from the group consisting of a target of a metal (for example, tantalum (Ta)) constituting the first hard mask film, a target of a compound of a metal constituting the first hard mask film (a target containing a metal constituting the first hard mask film, and oxygen (O), nitrogen (N), carbon (C) or others), and using, as a sputtering gas, a rare gas such as helium (He) gas, argon (Ar) gas, krypton (Kr) gas and xenon (Xe) gas, or according to the composition, the first hard mask film may be formed by reactive sputtering using, as sputtering gases, a reactive gas such as an oxygen-containing gas, a nitrogen-containing gas, a carbon-containing gas or other gases with the rare gas. Examples of the reactive gases include oxygen (O₂) gas, nitrogen (N₂) gas, nitrogen oxide gases such as nitrous oxide (N₂O) gas, nitrogen monoxide (NO) gas and nitrogen dioxide (NO₂) gas, and carbon oxide gases such as carbon monoxide (CO) gas and carbon dioxide (CO₂) gas.

A second hard mask film may be provided on the first hard mask film at the side remote from the substrate. This second hard mask is a film that acts as an etching mask in etching the first hard mask film, and it is required to have different etching characteristics to the first hard mask film. The second hard mask film is preferably formed in contact with the first hard mask film.

FIG. 2 is a cross-sectional view illustrating an example of a reflective mask blank (second embodiment) of the invention. This reflective mask blank 12 includes a substrate 1, and on the substrate 1, a multilayer reflection film 2 that is formed in contact with the substrate 1, a protection film 3 that is formed in contact with the multilayer reflection film 2, an etching prevention film 4 that is formed in contact with the protection film 3, an absorption film 5 that is formed in contact with the etching prevention film 4, a first hard mask film 6 that is formed in contact with the absorption film 5, and a second hard mask film 7 that is formed in contact with the first hard mask film 6.

The second hard mask film preferably contains chromium (Cr), and is preferably composed of a material containing chromium (Cr). The material containing chromium (Cr) has different etching characteristics to the first hard mask film in processing the first hard mask film composed of a material containing tantalum (Ta) and acts as an etching mask in etching the first hard mask film. Thus, the material containing chromium (Cr) for the second hard mask film is preferably free of tantalum (Ta).

Examples of the materials containing chromium (Cr) include simple substance of chromium (Cr) and chromium compounds containing chromium (Cr) and at least one selected from the group consisting of oxygen (O), nitrogen (N) and carbon (C). Particularly, the chromium compounds containing chromium (Cr) and at least one selected from the group consisting of oxygen (O), nitrogen (N) and carbon (C) are preferred. Examples of the chromium compounds include CrO, CrN, CrON, CrC, CrOC, CrNC and CrONC. In this case, the chromium compound has a chromium (Cr) content of preferably not less than 20 at%, more preferably not less than 30 at%. Further, the chromium compound has an oxygen (O) content of preferably not more than 50 at%, more preferably not more than 40 at%, a nitrogen (N) content of preferably not more than 40 at%, more preferably not more than 30 at%, or a carbon (C) content of preferably not more than 20 at%.

The second hard mask film has a thickness of not more than 20 nm, more preferably not more than 10 nm, even more preferably not more than 7 nm in the viewpoint of reduction of a thickness of a resist film in forming a pattern of the second hard mask film, however not particularly limited thereto. The thickness of the second hard mask film is generally not less than 5 nm.

The second hard mask film can be formed by sputtering, and the sputtering is preferably performed by a magnetron sputtering method. In particular, the second hard mask film may be formed by sputtering using an appropriate target selected, according to the composition, from the group consisting of a target of a metal (for example, chromium (Cr)) constituting the second hard mask film, a target of a compound of a metal constituting the second hard mask film (a target containing a metal constituting the second hard mask film, and oxygen (O), nitrogen (N), carbon (C) or others), and using, as a sputtering gas, a rare gas such as helium (He) gas, argon (Ar) gas, krypton (Kr) gas and xenon (Xe) gas, or according to the composition, the second hard mask film may be formed by reactive sputtering using, as sputtering gases, a reactive gas such as an oxygen-containing gas, a nitrogen-containing gas, a carbon-containing gas or other gases with the rare gas. Examples of the reactive gases include oxygen (O₂) gas, nitrogen (N₂) gas, nitrogen oxide gases such as nitrous oxide (N₂O) gas, nitrogen monoxide (NO) gas and nitrogen dioxide (NO₂) gas, and carbon oxide gases such as carbon monoxide (CO) gas and carbon dioxide (CO₂) gas.

A back surface conducting film used for electrostatic chucking a reflective mask to an exposure apparatus may be formed on the other main surface (back surface) which is the opposite surface to the one main surface in the substrate, preferably in contact with the other main surface.

The back surface conducting film preferably has a sheet resistance of not more than 100 Ω/square, and a material for the conducting film is not particularly limited. Examples of materials of the back surface conducting film include, for example, a material containing tantalum (Ta) or chromium (Cr). The material containing tantalum (Ta) or chromium (Cr) may contain oxygen (O), nitrogen (N), carbon (C), boron (B) or other elements. Examples of the materials containing tantalum (Ta) include, for example, simple substance of Ta, and a tantalum (Ta) compound such as TaO, TaN, TaON, TaC, TaCN, TaCO, TaCON, TaB, TaOB, TaNB, TaONB, TaCB, TaCNB, TaCOB and TaCONB. Examples of the materials containing chromium (Cr) include, for example, simple substance of Cr, and a chromium (Cr) compound such as CrO, CrN, CrON, CrC, CrCN, CrCO, CrCON CrB, CrOB, CrNB, CrONB, CrCB, CrCNB, CrCOB and CrCONB.

The back surface conducting film has a thickness of generally about 5 to 100 nm, however, not particularly limited thereto as long as the thickness is enough to act for electrostatic chucking use. The back surface conducting film is preferably formed so as to have a thickness at which film stresses between the back surface conducting film, and the film(s) and pattern(s) of the film(s) formed at the one main surface (front surface) side are balanced after making the reflective mask, i.e., after forming the pattern of the absorption film. The back surface conducting film may be formed before forming the multilayer reflection film, or after forming all the films on the substrate at the multilayer reflection film side. After forming a part of the films on the substrate at the multilayer reflection film side, the back surface conducting film may be formed, and then the remainder of the films at the multilayer reflection film side may be formed on the substrate. The back surface conducting film can be formed by, for example, a magnetron sputtering method.

The reflective mask blank may include a resist film formed on the side remotest from the substrate. The resist film is preferably an electron beam (EB) resist.

From the reflective mask blank, for example, a reflective mask including a substrate, a multilayer reflection film that is formed on one main surface of the substrate, a protection film that is formed in contact with the multilayer reflection film, a pattern of an etching prevention film that is formed in contact with the protection film, and a pattern of an absorption film that is formed in contact with the pattern of the etching prevention film can be obtained. In a reflective mask, a transfer pattern is formed by a difference in reflectance between a portion where an absorption film and an etching prevention film thereunder (at the substrate-side) are formed (a circuit pattern or a mask pattern), and a portion where the circuit pattern or the mask pattern is not formed.

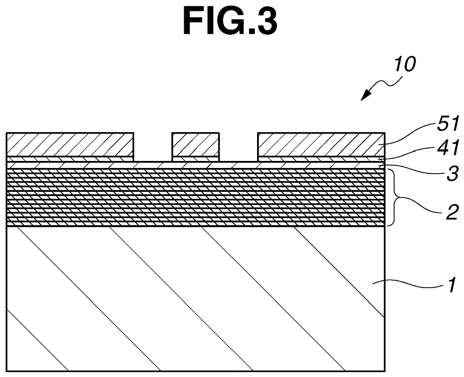

FIG. 3 is a cross-sectional view illustrating an example of a reflective mask of the invention. This reflective mask 10 includes a substrate 1, and on the substrate 1, a multilayer reflection film 2 that is formed in contact with the substrate 1, a protection film 3 that is formed in contact with the multilayer reflection film 2, a pattern of an etching prevention film 41 that is formed in contact with the protection film 3, and a pattern of an absorption film 51 that is formed in contact with the pattern of an etching prevention film 41. In this reflective mask 10, the pattern of the absorption film 51 is formed via the pattern of the etching prevention film 41 on the protection film 3.

From the reflective mask blank of the invention, a reflective mask can be manufactured by a method including the steps of:
etching the first hard mask film,
patterning the absorption film by etching, and
etching the etching prevention film.

Further, from the reflective mask blank including the second hard mask film, a reflective mask can be manufactured by a method including the steps of:
etching the second hard mask film,
etching the first hard mask film,
patterning the absorption film by etching, and
etching the etching prevention film.

In the case of manufacturing a reflective mask from the reflective mask blank not including the second hard mask film, in particular, a reflective mask can be manufactured by a method including the steps of:
preparing the reflective mask blank,
optionally forming a resist film on the first hard mask film,
forming a resist pattern from the resist film on the first hard mask film,
forming a pattern of the first hard mask film by etching the first hard mask film with using the resist pattern as an etching mask,
removing the resist pattern,
forming a pattern of the absorption film by etching the absorption film with using the pattern of the first hard mask film as an etching mask, and
removing the etching prevention film at a portion exposed by removing the absorption film, and the pattern of the first hard mask film, by etching.

On the other hand, in the case of manufacturing a reflective mask from the reflective mask blank including the second hard mask film, in particular, a reflective mask can be manufactured by a method including the steps of:
preparing the reflective mask blank,
optionally forming a resist film on the second hard mask film,
forming a resist pattern from the resist film on the second hard mask film,
forming a pattern of the second hard mask film by etching the second hard mask film with using the resist pattern as an etching mask,
removing the resist pattern,
forming a pattern of the first hard mask film by etching the first hard mask film with using the pattern of the second hard mask film as an etching mask, and
removing the pattern of the second hard mask film by etching,
forming a pattern of the absorption film by etching the absorption film with using the pattern of the first hard mask film as an etching mask, and
removing the etching prevention film at a portion exposed by removing the absorption film, and the pattern of the first hard mask film, by etching.

The resist film is preferably formed of an electron beam (EB) resist, and the resist pattern can be formed by drawing or exposing a pattern into the resist film by electron beam (EB) or others, and then developing. The resist pattern can be removed by washing with sulfuric acid-hydrogen peroxide mixture (SPM).

The etching for the absorption film is preferably ion beam etching or methanol etching. The etching for the absorption film may be performed by only either of ion beam etching and methanol etching, or by the combination of beam etching and methanol etching. In the case of the combination of both, ion beam etching is preferably performed followed by performing methanol etching.

Ion beam etching is a method in which a target to be etched is physically etched by colliding accelerated charged particles (ions). Examples of charged particles (ions) used in ion beam etching include charged particles (ions) of rare gases such as xenon (Xe) gas and argon (Ar) gas. Among them, charged particles (ions) of argon (Ar) gas are preferably used. On the other hand, methanol etching is dry etching using methanol gas.

Etching for forming a pattern of the absorption film may be performed by initially performing ion beam etching, switching to methanol etching before the absorption film is completely etched, i.e., when at least a part in the thickness direction, preferably a small thickness (for example, a thickness of about 1 to 5 nm) of the absorption film is remained, and etching the remainer of the absorption film by methanol etching to etching the whole of the absorption film. Particularly, this method is suitable in the case that the metal contained in the absorption film is platinum (Pt) or nickel (Ni).

Etching for the first hard mask film and its pattern, etching for the second hard mask film and its pattern, and etching for the etching prevention film, respectively, are preferably dry etching using a chlorine-based gas or a fluorine-based gas. Particularly, dry etching using a chlorine-based gas for the second hard mask film and its pattern is preferably dry etching using a chlorine-based gas containing chlorine (Cl) and oxygen (O). For example, a film containing tantalum (Ta) can be etched by dry etching using a fluorine-based gas. The film containing tantalum (Ta) can be etched also by dry etching using a chlorine-based gas. In the case of etching the film containing tantalum (Ta) by dry etching using a chlorine-based gas, the etching is preferably performed by combining with etching using a fluorine-based gas. On the other hand, a film containing chromium (Cr) can be etched by dry etching using a chlorine-based gas, particularly, dry etching using a chlorine-based gas containing chlorine (Cl) and oxygen (O). For etching the pattern of the first hard mask film the same etching for patterning of the first hard mask film may be applied, and for etching the pattern of the second hard mask film the same etching for patterning of the second hard mask film may be applied.

To avoid damages of the protection film, further to avoid damages of the multilayer reflection film that are formed under (at the substrate-side of) the absorption film, etching for the absorption film is preferably performed such that the etching prevention film is not completely disappeared, i.e., at least a part in the thickness direction of the etching prevention film is remained, after etching in patterning the absorption film.

The etching prevention film at a portion exposed by removing the absorption film, and the pattern of the first hard mask film may be removed at the same time by the same etching. In this case, to avoid damages of the protection film, further to avoid damages of the multilayer reflection film that are formed under (at the substrate-side of) the absorption film, the etching is preferably performed such that the pattern of the first hard mask film is removed before completely removing the etching prevention film at the portion exposed by removing the absorption film.

In the invention, an etching prevention film may be provided so as to contact with both of a protection film and an absorption film, and a first hard mask film may be provided on the absorption film, and a pattern of the absorption film can be formed by the steps of:
forming a pattern of the first hard mask film by dry etching,
patterning the absorption film by ion beam etching or ion beam etching and methanol etching with using the pattern of the first hard mask film as an etching mask, and
removing the etching prevention film by dry etching.
In this case, a second hard mask film may be further provided on the first hard mask film, and
a pattern of the second hard mask film may be formed by dry etching using a gas containing chlorine (Cl) and oxygen (O), and
the pattern of the first hard mask film may be formed with using the pattern of the second hard mask film as an etching mask.

By providing the etching prevention film between the protection film and the absorption film, a reflective mask can be manufactured without damaging the films provided under (at the substrate-side of) the absorption film even when the absorption film is etched by ion beam etching or methanol etching in patterning the absorption film.

### EXAMPLES

Examples of the invention are given below by way of illustration and not by way of limitation.

### Example 1

On a titania-doped quartz substrate having dimensions of 152 mm-square and 6 mm-thick. a multilayer reflection film (thickness: 280 nm, reflectance with respect to light having a wavelength of 13.5 nm: 65%) of a laminated film in which layers composed of molybdenum (Mo) and layers composed of silicon (Si) are alternately laminated was formed by sputtering using, as targets, a molybdenum (Mo) target and a silicon (Si) target, and, as a sputtering gas, argon (Ar) gas.

Next, a protection film (thickness: 5 nm) composed of ruthenium (Ru) was formed by sputtering using, a target, a ruthenium (Ru) target, and, as a sputtering gas, argon (Ar) gas.

Next, an etching prevention film (thickness: 5 nm) composed of tantalum nitride (TaN, Ta: 52 at%, N: 48 at%) was formed by sputtering using, a target, a tantalum (Ta) target, and, as sputtering gases, argon (Ar) gas and nitrogen (N₂) gas.

Next, an absorption film (thickness: 20 nm) composed of nickel (Ni) was formed by sputtering using, a target, a nickel (Ni) target, and, as a sputtering gas, argon (Ar) gas.

Next, a first hard mask film (thickness: 15 nm) composed of tantalum nitride (TaN, Ta: 52 at%, N: 48 at%) was formed by sputtering using, a target, a tantalum (Ta) target, and, as sputtering gases, argon (Ar) gas and nitrogen (N₂) gas.

Next, a second hard mask film (thickness: 10 nm) composed of chromium nitride (CrN, Cr: 87 at%, N: 13 at%) was formed by sputtering using, a target, a chromium (Cr) target, and, as sputtering gases, argon (Ar) gas and nitrogen (N₂) gas to obtain a reflective mask blank.

A reflective mask was manufactured from the obtained reflective mask blank. First, a resist pattern was formed by coating a resist film (thickness: 100 nm) on the second hard mask film, irradiating an electron beam, and developing.

Next, a pattern of the second hard mask film composed of chromium nitride (CrN) was formed by dry etching using a chlorine-based gas with using the resist pattern as an etching mask under the following conditions.

### <Dry etching conditions for second hard mask film>

Apparatus: ICP (Inductively Coupled Plasma) method
Gas: Chlorine (Cl₂) gas (flow rate: 185 sccm), and oxygen (O₂) gas (flow rate: 2 sccm)
Gas pressure: 6 mTorr (0.8 Pa)
ICP power: 400W

Next, the resist pattern was removed by SPM cleaning.

Next, a pattern of the first hard mask film composed of tantalum nitride (TaN) was formed by dry etching using a fluorine-based gas with using the pattern of the second hard mask film as an etching mask under the following conditions.

### <Dry etching conditions for first hard mask film>

Apparatus: ICP (Inductively Coupled Plasma) method
Gas: Sulfur hexafluoride (SF₆) gas, and helium (He) gas
Gas pressure: 4 mTorr (0.53 Pa)
ICP power: 400W

Next, the pattern of the second hard mask film composed of chromium nitride (CrN) was removed by dry etching using a chlorine-based gas under the above dry etching conditions for second hard mask film.

Next, a pattern of the absorption film composed of nickel (Ni) was formed by ion beam etching with using the pattern of the first hard mask film as an etching mask under the following conditions.

### <Ion beam etching conditions for absorption film>

Gas: Ar (flow rate: 1.5 cm³/min)
Accelerating voltage: 2 kV
Beam current: 165 µA

Next, by dry etching using a fluorine-based gas under the above dry etching conditions for first hard mask film, the pattern of the first hard mask film composed of tantalum nitride (TaN) was removed with removing the etching prevention film composed of tantalum nitride (TaN) at the portion exposed by removing the absorption film, and the dry etching using a fluorine-based gas was terminated when the pattern of the first hard mask film was completely removed.

Next, the remainder of the etching prevention film composed of tantalum nitride (TaN) was removed by dry etching using a chlorine-based gas under the following conditions to obtain a reflective mask.

### <Dry etching conditions for etching prevention film>

Apparatus: ICP (Inductively Coupled Plasma) method
Gas: Chlorine (Cl₂) gas
Gas pressure: 3 mTorr (0.40 Pa)
ICP power: 350W

By checking the obtained reflective mask, it was found that the absorption film composed of nickel (Ni) had been etched, the pattern of the absorption film had been formed in a predetermined shape, and the protection film composed of ruthenium (Ru) exposed at the portion where the absorption film did not exist in the reflective mask had not been damaged by the etching.

### Example 2

A reflective mask blank was obtained in the same manner as in Example 1, except that an absorption film (thickness: 20 nm) composed of platinum (Pt) was formed with using, as a target, a platinum (Pt) target. Next, a reflective mask was obtained from the reflective mask blank in the same manner as in Example 1.

By checking the obtained reflective mask, it was found that the absorption film composed of platinum (Pt) had been etched, the pattern of the absorption film had been formed in a predetermined shape, and the protection film composed of ruthenium (Ru) exposed at the portion where the absorption film did not exist in the reflective mask had not been damaged by the etching.

### Comparative Example 1

A reflective mask blank was obtained in the same manner as in Example 1, except that the second hard mask film and the etching prevention film were not formed, and the absorption film was directly formed on the protection film.

A reflective mask was manufactured from the obtained reflective mask blank. First, a resist pattern was formed by coating a resist film (thickness: 100 nm) on the first hard mask film, irradiating an electron beam, and developing.

Next, a pattern of the first hard mask film composed of tantalum nitride (TaN) was formed by dry etching using a fluorine-based gas with using the resist pattern as an etching mask under the dry etching conditions for first hard mask film in Example 1.

Next, the resist pattern was removed by SPM cleaning.

Next, a pattern of the absorption film composed of nickel (Ni) was formed by ion beam etching with using the pattern of the first hard mask film as an etching mask under the ion beam etching conditions for absorption film in Example 1.

Next, the pattern of the first hard mask film composed of tantalum nitride (TaN) was removed by dry etching using a fluorine-based gas under the above dry etching conditions for first hard mask film to obtain a reflective mask.

By checking the obtained reflective mask, it was found that the absorption film composed of nickel (Ni) had been etched, and the pattern of the absorption film had been formed in a predetermined shape, however, it was found that the protection film composed of ruthenium (Ru) exposed at the portion where the absorption film did not exist in the reflective mask had been etched, and a part of the multilayer reflection film had been exposed.

### Comparative Example 2

A reflective mask blank was obtained in the same manner as in Example 1, except that the second hard mask film and the etching prevention film were not formed, the absorption film was directly formed on the protection film, and as the absorption film, an absorption film (thickness: 20 nm) composed of chromium nitride (CrN, Cr: 87 at%, N: 13 at%) was formed by sputtering using, a target, a chromium (Cr) target, and, as sputtering gases, argon (Ar) gas and nitrogen (N₂) gas.

A reflective mask was manufactured from the obtained reflective mask blank. First, a resist pattern was formed by coating a resist film (thickness: 100 nm) on the first hard mask film, irradiating an electron beam, and developing.

Next, a pattern of the first hard mask film composed of tantalum nitride (TaN) was formed by dry etching using a fluorine-based gas with using the resist pattern as an etching mask under the dry etching conditions for first hard mask film in Example 1.

Next, the resist pattern was removed by SPM cleaning.

Next, a pattern of the absorption film composed of chromium nitride (CrN) was formed by ion beam etching with using the pattern of the first hard mask film as an etching mask under the ion beam etching conditions for absorption film in Example 1.

Next, the pattern of the first hard mask film composed of tantalum nitride (TaN) was removed by dry etching using a fluorine-based gas under the above dry etching conditions for first hard mask film to obtain a reflective mask.

By checking the obtained reflective mask, it was found that the absorption film composed of chromium nitride (CrN) had been etched, and the pattern of the absorption film had been formed in a predetermined shape, however, it was found that the protection film composed of ruthenium (Ru) exposed at the portion where the absorption film did not exist in the reflective mask had been etched, and a part of the multilayer reflection film had been exposed.

## Claims

1. A reflective mask blank which is a material for a reflective mask used in EUV lithography utilizing EUV light as exposure light, comprising
a substrate,
a multilayer reflection film that is formed on one main surface of the substrate, and reflects the exposure light,
a protection film that is formed on the multilayer reflection film, and
an absorption film that is formed on the protection film, and absorbs the exposure light, wherein
the reflective mask blank comprises an etching prevention film that is formed in contact with both of the protection film and the absorption film, and a first hard mask film that is formed on the absorption film.

2. The reflective mask blank of claim 1 wherein
the etching prevention film has an etching selectivity of less than 1 to the absorption film when ion beam etching is performed to the absorption film and the etching prevention film under the same condition;
the etching prevention film has an etching selectivity of less than 1 to the absorption film when methanol etching is performed to the absorption film and the etching prevention film under the same condition;
the etching prevention film has an etching selectivity of more than 1 to the absorption film when dry etching using a chlorine-based gas or a fluorine-based gas is performed to the absorption film and the etching prevention film under the same condition; or
the absorption film has an etching selectivity of not more than 0.3 to the first hard mask film when dry etching using a chlorine-based gas or a fluorine-based gas is performed to the first hard mask film and the absorption film under the same condition.

3. The reflective mask blank of claim 1 or 2 wherein the absorption film comprises a metal excluding tantalum (Ta), preferably comprises at least one metal selected from the group consisting of platinum (Pt), nickel (Ni), gold (Au), palladium (Pd), rhodium (Rh), iridium (Ir), silver (Ag), iron (Fe), cobalt (Co) and zinc (Zn).

4. The reflective mask blank of claim 3 wherein either or both of the etching prevention film and the first hard mask film comprise tantalum (Ta), preferably each of the etching prevention film and the first hard mask film comprises tantalum (Ta) and nitrogen (N).

5. The reflective mask blank of any one of claims 1 to 4 wherein the multilayer reflection film comprises a high refractive index layer composed of a material containing silicon (Si) and a low refractive index layer composed of a material containing molybdenum (Mo).

6. The reflective mask blank of any one of claims 1 to 5 wherein the protection film comprises ruthenium (Ru).

7. The reflective mask blank of any one of claims 1 to 6 further comprising a second hard mask film on the first hard mask film, preferably the second hard mask film comprises chromium (Cr).

8. A manufacturing method of a reflective mask from the reflective mask blank of any one of claims 1 to 7, comprising the steps of:
dry etching the second hard mask film with using a gas comprising chlorine (Cl) and oxygen (O) in the case that the reflective mask blank comprises the second hard mask film,
dry etching the first hard mask film with using a chlorine-based gas or a fluorine-based gas,
patterning the absorption film by ion beam etching or ion beam etching and methanol etching, and
dry etching the etching prevention film with using a chlorine-based gas or a fluorine-based gas.

9. A manufacturing method of a reflective mask from a reflective mask blank comprising
a substrate,
a multilayer reflection film that is formed on one main surface of the substrate, and reflects exposure light,
a protection film that is formed on the multilayer reflection film, and
an absorption film that is formed on the protection film, and absorbs the exposure light, by patterning the absorption film, wherein
in the reflective mask blank, an etching prevention film is provided so as to contact to both of the protection film and the absorption film, and a first hard mask film is provided on the absorption film, wherein
the method comprises the patterning of the absorption film by the steps of:
forming a pattern of the first hard mask film by dry etching using a chlorine-based gas or a fluorine-based gas,
patterning the absorption film by ion beam etching or ion beam etching and methanol etching with using the pattern of the first hard mask film as an etching mask, and
removing the etching prevention film by dry etching using a chlorine-based gas or a fluorine-based gas.

10. The method of claim 9 wherein
in the reflective mask blank, a second hard mask film is further provided on the first hard mask film, and
a pattern of the second hard mask film is formed by dry etching using a gas comprising chlorine (Cl) and oxygen (O), and
the pattern of the first hard mask film is formed with using the pattern of the second hard mask film as an etching mask.

11. The method of claim 9 or 10 wherein
the etching prevention film has an etching selectivity of less than 1 to the absorption film in the ion beam etching;
the etching prevention film has an etching selectivity of less than 1 to the absorption film in the methanol etching;
in the removing step of the etching prevention film, the etching prevention film has an etching selectivity of more than 1 to the absorption film in the dry etching using a chlorine-based gas or a fluorine-based gas; or
in the forming step of the pattern of the first hard mask film, the absorption film has an etching selectivity of not more than 0.3 to the first hard mask film in the dry etching using a chlorine-based gas or a fluorine-based gas.

12. The method of any one of claims 9 to 11 wherein the absorption film comprises a metal excluding tantalum (Ta), preferably comprises at least one metal selected from the group consisting of platinum (Pt), nickel (Ni), gold (Au), palladium (Pd), rhodium (Rh), iridium (Ir), silver (Ag), iron (Fe), cobalt (Co) and zinc (Zn).

13. The method of claim 12 wherein either or both of the etching prevention film and the first hard mask film comprise tantalum (Ta), preferably each of the etching prevention film and the first hard mask film comprises tantalum (Ta) and nitrogen (N).

14. The method of any one of claims 9 to 13 wherein the multilayer reflection film comprises a high refractive index layer composed of a material containing silicon (Si) and a low refractive index layer composed of a material containing molybdenum (Mo).

15. The method of any one of claims 9 to 14 wherein the protection film comprises ruthenium (Ru).
